# FASCICULE DE BREVET EUROPEEN

(11) **EP 2 252 550 B1**
(45) Date de publication et mention de la délivrance du brevet: **08.05.2013**
(21) Numéro de dépôt: 09718657.1
(22) Date de dépôt: 18.02.2009
(51) Int. Cl.: C01B 33/029, C01B 33/04, C23C 16/455

(54) **PROCEDE DE RECYCLAGE DE SILANE (SiH4)**
VERFAHREN ZUM RECYCLING VON SILAN (SIH4)
METHOD FOR RECYCLING SILANE (SIH4)

(30) Priorité: 04.03.2008 US 33665; 11.07.2008 FR 0854746
(43) Date de publication de la demande: 24.11.2010
(73) Titulaire: L'Air Liquide Société Anonyme pour l'Etude et l'Exploitation des Procédés Georges Claude, 75007 Paris (FR)
(72) Inventeur: BRIEND, Pierre, F-38170 Seyssinet (FR); ALBAN, Bruno, F-91300 Massy (FR); CHEVREL, Henri, F-78150 Le Chesnay (FR); JAHAN, Denis, F-92150 Suresnes (FR)
(74) Mandataire: Grout de Beaufort, François-Xavier
(86) Numéro de dépôt international: PCT/FR2009/050262
(87) Numéro de publication internationale: WO 2009/112730

(56) Documents cités:
- EP-A- 0 771 887
- WO-A-2008/154293
- CA-A1- 1 162 028
- DE-A1- 2 918 066
- JP-A- 58 223 612

## Description

La présente invention concerne un procédé de recyclage de silane (SiH₄) et d'hydrogène (H₂).

La réduction du coût de l'énergie solaire passe par la réduction du coût de fabrication des cellules photovoltaïques. Pour la filière technologique dite « couches minces », notamment pour l'application où le silicium est déposé en couche mince, et plus particulièrement pour la solution silicium micro cristallin et amorphe, la réduction de la consommation des gaz utilisés pour les dépôts des couches actives contribue à la diminution globale du coût de fabrication.

La production de cellules photovoltaïques avec couches minces de silicium micro cristallin et / ou amorphe nécessite la mise en oeuvre des gaz tels que H₂, SiH₄, des gaz dopants tels que TMB - TriMethyl Bore, PH₃ - phosphine, B₂H₆ - diborane et aussi N₂, argon... Ces productions de cellules solaires seront bientôt réalisées dans des usines dont les capacités atteindront prochainement plusieurs centaines de mégawatts chaque année.

La production des couches minces de silicium pour les piles solaires exige le dépôt séquentiel de couches de silicium dopées p, non dopées et dopées n sur un substrat. Chaque dépôt de silicium est conduit dans une chambre dans laquelle une méthode choisie parmi CVD, (dont MOCVD, PECVD, ALD, HWCVD, APCVD, VTD ...) ou PVD (en particulier évaporation et pulvérisation) est exécutée.

Par exemple, le substrat est situé dans une première chambre dans laquelle un mélange de gaz contenant du silane, un dopant tel que le TMB et l'hydrogène comme gaz porteur est fourni pour façonner une couche de silicium de type p sur le substrat. Le substrat est alors déplacé vers une deuxième chambre dans laquelle un mélange de gaz d'hydrogène et de silane est fourni pour la conception d'une couche non dopée. Le substrat peut alors être déplacé vers une troisième chambre dans laquelle un mélange de gaz comportant de l'hydrogène comme gaz porteur, du silane et un dopant tel que la phosphine PH₃ est fourni pour la réalisation d'une couche dopée n sur le substrat. Il y a une évolution dans ce type de fabrication de tels dispositifs : les substrats sur lesquels sont effectués ces dépôts sont de plus en plus grands. Ainsi, la taille des chambres de dépôt et les débits d'introduction des gaz, en particulier de l'hydrogène en tant que gaz porteur doivent également être augmentés. Dans les dispositifs actuels, les gaz non utilisés dans les chambres de dépôt sont aspirés à l'aide d'une pompe avant d'être traités afin de détruire les effluents dangereux.

Les quantités de gaz nécessaires aux dépôts des couches actives cibles sont très importantes. Du fait de la taille des usines en projet et du besoin intrinsèque en gaz lié à la nature de la technologie, les débits nécessaires vont atteindre des dizaines, voire des centaines de m³ par heure pour l'hydrogène. La fourniture de gaz devient donc problématique pour l'hydrogène mais aussi pour le silane. Les volumes requis sont un frein au déploiement de ces technologies.

Une façon de réduire le coût de la fourniture et de la logistique du silane (SiH₄) et de l'hydrogène (H₂) est de recycler ces gaz à leur sortie des réacteurs de dépôt.

Cependant, les gaz réintroduits dans le réacteur doivent répondre aux spécifications requises pour obtenir des couches de bonne qualité.

Les spécifications principales sont les suivantes : concentrations en H₂O, O₂ et N₂ < 1 ppm dans SiH₄ et H₂ afin d'éviter la formation d'oxydes et/ou de nitrures; concentrations en gaz dopants tels PH₃, B₂H₆, TMB maîtrisées en fonction du type et du niveau de dopage souhaité. De plus, des poudres peuvent se former en grandes quantités au cours de la réaction ; leur concentration doit donc être rapportée à une valeur acceptable, c'est-à-dire à un niveau suffisamment faible pour être compatible par exemple: avec le mode de fonctionnement des différents composants dans lesquels les gaz contenant ces poudres vont circuler, et avec l'application visée (par exemple le dépôt de couches minces pour la réalisation de cellules solaires). Ces composants sont par exemple des compresseurs, des unités d'adsorption.... En outre, le rapport SiH₄/H₂ et le débit de ces gaz doivent pouvoir être contrôlés.

Du fait de la technologie actuelle, la problématique énoncée ci-dessus est apparue nouvelle. Cependant, la littérature révèle quelques caractéristiques.

Un recyclage des gaz de rejet est par exemple décrit dans le document JP58223612A « Apparatus for forming amorphous silicon film ». La demande de brevet publiée en 1983, présente une solution pour améliorer le taux d'utilisation du silane lors du dépôt d'un film de silicium amorphe par CVD assistée par plasma (Plasma Enhanced Chemical Vapor Deposition) : il s'agit d'une séparation de l'hydrogène des gaz récupérés en sortie du réacteur de dépôt puis d'un recyclage du silane en entrée de ce même réacteur. Ce document expose une solution où la séparation et le recyclage nécessitent notamment la mise en oeuvre d'un piège froid utilisant de l'azote liquide. Mais il n'aborde pas la problématique du recyclage de l'hydrogène. D'autre part, le procédé est mis en oeuvre sous vide ce qui présente un danger difficile à maîtriser parfaitement pour la manipulation du silane qui est un réducteur très violent, donc avide d'oxydant comme l'oxygène contenu dans l'air qui pourrait rentrer dans le procédé par exemple.

Dans le domaine photovoltaïque, jusqu'à présent, la solution détaillée dans la demande de brevet JP58223612A commentée ci-dessus n'a pas été mise en oeuvre pour séparer puis recycler les gaz utilisés comme précurseurs des dépôts de couches minces. D'autre part, aucune solution n'est actuellement industrialisée pour réaliser la récupération des gaz silane et / ou hydrogène et assurer leur réutilisation dans le procédé de dépôt de couches de silicium. Les gaz rejetés sont simplement traités et évacués.

Par ailleurs, le brevet US 5,785,741 « Process and system for separation and recovery of perfluorocompounds gases » présente une solution pour la séparation des gaz PFC en vue de leur recyclage. Cette solution peut être mise en oeuvre dans l'industrie de la microélectronique. Des laveurs, des filtres, des membranes, des pièges froids et des PSA (Pressure Swing Adsorber) sont requis pour aboutir au recyclage de ces gaz PFC. Cette solution est intéressante mais une forme améliorée et simplifiée de cette méthode est indispensable pour mettre en oeuvre d'autres gaz (silane et hydrogène par exemple) et dans un autre domaine (cas de l'industrie photovoltaïque par exemple).

Pour la séparation du silane de l'hydrogène, des solutions sont écrites dans le document EP 0 644 153 « Procédé de séparation du silane à l'aide d'une membrane » et « Séparation of hydrogen from silane via membranes : a step in the production of ultra-high purity silicon » traitant de l'utilisation d'une membrane pour séparer le silane de l'hydrogène utilisé dans de la fabrication du silicium de haute pureté. Cet élément peut être mis en oeuvre pour la solution développée pour le recyclage du silane et de l'hydrogène pour l'application relative au dépôt de silicium amorphe en couches minces. Néanmoins, il s'agit d'une brique de la solution technologique élaborée pour réaliser ce recyclage. D'autre part, la séparation par membrane ne peut pas fournir des gaz de haute pureté, ce qui est pourtant indispensable dans les applications visées ci-dessus.

Pour finir, dans le brevet EP 0 645 345, il est décrit un procédé de séparation par membrane d'un hydrure gazeux ou d'un mélange d'hydrures gazeux (tels que PH₃, AsH₃, Si₂H₆), d'un milieu gazeux contenant au moins de l'argon, de l'hélium et / ou de l'hydrogène. La solution proposée permet donc de concentrer, d'un côté les hydrures gazeux (en l'occurrence les gaz utilisés pour le dopage dans le cas d'une application pour l'industrie photovoltaïque) et de ne laisser passer à travers la membrane, de l'autre côté appellé aussi perméat, que le mélange argon, hélium et / ou hydrogène. Une telle séparation est réalisée avec une membrane polymère de type polyimide ou polyaramide.

En conséquence, aucune solution satisfaisante n'a été mise en oeuvre jusqu'à présent pour réaliser de manière efficace et intégrée les différentes étapes nécessaires à la réalisation du recyclage de gaz utilisés dans la fabrication de structures notamment formées de films de silicium, dopés ou non, et déposés en couches minces.

En résumé, afin de réduire la consommation en hydrogène et / ou silane pour la fabrication de systèmes composés de couches minces de silicium déposées par exemple par CVD ou PVD, tels que notamment les cellules photovoltaïques en couches minces de silicium, les bénéfices que la solution doit apporter sont par exemple:
- La séparation des poudres d'un effluent gazeux (effluent récupéré en sortie d'un réacteur de dépôt de couches minces de silicium amorphe) ;
- La concentration du silane dans un mélange silane / hydrogène ;
- La séparation des gaz à recycler de l'azote utilisé dans le groupe de pompage soit en ballaste soit en dilution en aval de(s) la chambre(s) ;
- La séparation des gaz dopants du silane ou de l'hydrogène ;
- La mise à disposition des gaz silane et hydrogène en vue de leur réintroduction dans le réacteur de dépôt et de leur réutilisation pour lesdits dépôts.

Un but de la présente invention est de pallier tout ou partie des inconvénients de l'art antérieur relevés ci-dessus.

A cette fin, l'invention a pour objet un procédé de recyclage de silane comprenant les étapes successives suivantes:
a) Injection d'un mélange silane pur/hydrogène pur (SiH₄/H₂) dans une chambre de réaction pour fabriquer des couches minces contenant du silicium ;
b) Extraction du mélange : excès de silane non utilisé à l'étape a) / hydrogène (SiH₄/H₂), au moyen d'une pompe mettant en oeuvre un gaz d'alimentation ;
c) Refoulement de ladite pompe à une pression proche de la pression atmosphérique, d'un mélange comprenant au moins du silane (SiH₄), de l'hydrogène (H₂) et une quantité non nulle dudit gaz d'alimentation;
d) Séparation du silane (SiH₄) du mélange hydrogène/gaz d'alimentation issus du mélange issu de l'étape c), ledit silane obtenu comprenant moins de 100 ppm de gaz d'alimentation, de préférence moins de 10 ppm de gaz d'alimentation, de préférence moins de 1 ppm de gaz d'alimentation ;
caractérisé en ce qu'au moins 50%, de préférence 70%, et de préférence encore 80% du silane (SiH₄) issu de l'étape b) est réutilisé après l'étape d) pour une nouvelle étape a).

Ledit gaz d'alimentation est un gaz lourd permettant l'entraînement de l'hydrogène hors de ladite chambre de réaction ainsi qu'une lubrification de la pompe satisfaisante. Le gaz d'alimentation est par exemple de l'azote ou de l'argon. De manière préférée, le gaz d'alimentation est l'azote.

Par gaz pur on entend des gaz comprenant moins de 1 ppm d'impuretés, par exemple moins de 1 ppm d'azote. Les dopants tels que cités plus haut ne sont pas considérés comme des impuretés.

L'invention a également pour objet un procédé de recyclage de silane et d'hydrogène mettant en oeuvre le procédé tel que défini ci-dessus, comprenant en outre une étape de:
e) Purification de l'hydrogène (H₂) issus de l'étape d) telle que le taux de gaz d'alimentation dans l'hydrogène n'est pas supérieur à 100 ppm, de préférence pas supérieur à 10 ppm, de préférence pas supérieur à 1 ppm ;
caractérisé en ce qu'au moins 50%, de préférence 70%, et de préférence encore 85% de l'hydrogène (H₂) issu de l'étape b) est réutilisé après l'étape e) pour une nouvelle étape a).

La technique de fabrication de couche mince par dépôt de métal sous vide est une pratique très utilisée. A très basse pression (de l'ordre du centième de Pascal), les molécules de vapeur d'un métal se déplacent avec très peu de risque de collision avec d'autres molécules. Les molécules de vapeur de métal se trouvent projetées sur un substrat sans être freinées par les phénomènes de diffusion et sans risque de d'oxydation. La couche obtenue est ainsi très pure et très régulière.

Par ailleurs, des modes de réalisation du procédé de l'invention peuvent comporter l'une ou plusieurs des caractéristiques suivantes :

Procédé tel que précédemment défini, caractérisé en ce que ledit gaz d'alimentation de la pompe est l'azote (N₂). Procédé tel que précédemment défini, caractérisé en ce que le mélange issu de l'étape c) comprend de 30% à 90% d'azote (N₂), de préférence de 60% à 80% d'azote (N₂).

Procédé tel que précédemment défini, comprenant en outre une étape de compression entre les étapes c) et d), au cours de laquelle la pression en sortie de pompe proche de la pression atmosphérique, est augmentée à une pression comprise entre 2 bars et 35 bars, de préférence entre 5 bars et 15 bars et de préférence encore entre 8 bars et 10 bars.

Procédé tel que précédemment défini, comprenant en outre une étape de filtration avant l'étape d), des impuretés contenues dans le mélange issu de l'étape c).

Procédé tel que précédemment défini, comprenant en outre une étape d'adsorption d'eau après compression et avant étape d). En effet, parmi les impuretés présentes dans le mélange issu de l'étape c), il peut se trouver de l'eau. Le moyen d'adsorption est par exemple un PSA ou un TSA. Le dit moyen d'adsorption étant alors présent dans l'appareil (défini ci-dessous) mettant en oeuvre le procédé selon l'invention. Procédé tel que précédemment défini, caractérisé en ce que l'étape d) est effectuée par séparation et/ou distillation cryogénique.

Procédé tel que précédemment défini, caractérisé en ce que le mélange injecté à l'étape a) comprend moins de 50% de silane (SiH₄) dans de l'hydrogène (H₂) et de préférence moins de 25%. Le procédé selon l'invention peut aussi être mis en oeuvre pour un mélange injecté à l'étape a) contenant plus de 50% de silane.

Procédé tel que précédemment défini, caractérisé en ce que le rapport : concentration de silane (SiH₄) sur concentration d'hydrogène (H₂) est contrôlé et ajusté si nécessaire avant réinjection, pour une nouvelle étape a), du mélange silane/hydrogène (SiH₄/H₂) comprenant au moins du silane (SiH₄) recyclé selon ledit procédé.

Procédé tel que précédemment défini, caractérisé en ce que la fabrication des couches minces dans la chambre de réaction est faite sous vide.

Une caractéristique essentielle du procédé selon l'invention est le recyclage du silane et si nécessaire de l'hydrogène, effectué autrement que sous vide. En effet, le silane est un gaz très réactif avec l'air donc il est très difficile à manipuler autrement qu'en utilisant des membranes ou alors par absorption mais ces techniques ne sont pas satisfaisantes lorsqu'un gaz à recycler requière une exigence de pureté. De plus, la manipulation du silane sous vide représente un grand danger en terme de sécurité dû au risque de la pénétration d'air, d'oxygène ou d'humidité.

D'autre part, le fait de mettre en oeuvre un procédé à une pression relativement élevée (à pression atmosphérique ou plus) permet d'optimiser les blocs de l'appareil permettant la réalisation du procédé selon l'invention.

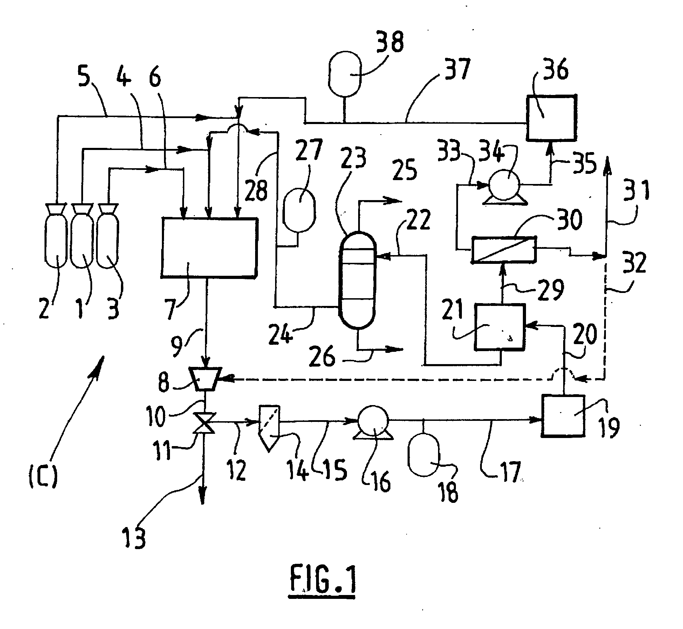

D'autres particularités et avantages apparaîtront à la lecture de la description ci-après, faite en référence à la figure 1:
- la figure 1 représente un schéma d'un exemple de circuit de recyclage selon l'invention et apte à mettre en oeuvre le procédé objet de la présente invention.

Sur la figure 1 est représenté un circuit de recyclage (C) comprenant une source 1 de précurseur de silicium, en particulier le gaz silane (SiH₄), une source d'hydrogène 2. L'hydrogène peut-être employé en tant que gaz porteur. L'appareil comprend également une source 3 de gaz dopants tels que TMB - TriMethyl Bore, PH₃ - phosphine, B₂H₆ - diborane destinés à la fabrication des couches minces pour les applications mentionnées ci-dessus. D'autres gaz peuvent-étre utilisés en fonction de l'application visée. Les gaz issus de ces sources sont ensuite injectés, via les lignes de gaz 4, 5, 6 dans la chambre de réaction 7 où a lieu le dépôt des couches minces.

Par exemple, ledit mélange comporte au plus 50% de silane dans l'hydrogène, de préférence moins de 25% de silane. La concentration en éléments dopants est généralement inférieure à 5% et dépend du niveau de dopage voulu et de l'efficacité de dopage du précurseur utilisé. Ainsi, le rapport, en concentrations, entre H₂ et SiH₄ est choisi avec précision et doit être contrôlé avant que le mélange soit introduit dans la chambre de réaction 7.

Une fois ledit mélange injecté dans la chambre de réaction 7, le dépôt a lieu, Au cours du dépôt, une quantité du précurseur de silicium, en particulier le silane, préalablement introduit pouvant atteindre jusqu'à 85% n'est pas utilisée lors de la réaction à l'intérieur de la chambre. Un objectif de la présente invention étant de recycler la totalité ou la quasi-totalité de cette quantité non utilisée, les autres composants de l'appareil ont pour utilité le recyclage de ce silane. Selon une variante du procédé selon l'invention, outre le silane, l'hydrogène est également recyclé. En aval de la chambre de réaction 7, une pompe 8 est présente. Cette pompe 8 aspire un mélange: excès de silane non utilisé dans la chambre 7 / hydrogène (SiH₄/H₂) à travers un conduit 9 dans lequel la pression est de quelques millibars. Ledit mélange peut comprendre en outre des impuretés telles que par exemple H₂O, O₂, des traces de dopants comme PH₃, B₂H₆, TMB, des particules formées dans le réacteur issues de la décomposition du plasma introduit. La pompe 8 est par exemple alimentée en azote (N₂) (utilisé ici comme « gaz d'alimentation » comme défini ci-dessus) en particulier pour ses qualités d'inertage, de lubrifiant et d'entrainement des gaz légers. Il en résulte qu'en sortie de la pompe 8, un mélange comprenant, entre autre, de l'azote, du silane (en général de 0.01% à 15%) et de l'hydrogène (de 10% à 80 %) circule à une pression proche de la pression atmosphérique dans un conduit 10.

Une vanne trois voies 11 peut-être installée afin de diriger le mélange soit vers la canalisation 12 afin de le recycler, soit vers la canalisation 13 et les équipements de retraitement et l'évent. Ceci permet, par exemple, de sélectionner les mélanges, sortant de la chambre de réaction 7, à recycler en fonction des mélanges injectés dans cette même chambre de réaction 7. La vanne 11 permet aussi l'évacuation du mélange venant de la canalisation 10 vers la canalisation 13 en cas de défaillance du circuit de recyclage, de sorte que si le procédé de recyclage selon l'invention ne peut pas fonctionner, l'évacuation des gaz issus de la chambre de réaction 7 a lieu comme dans les systèmes standards de l'état de la technique.

Le mélange circulant dans la canalisation 12 peut également comporter des impuretés comme celles qui ont été décrites précédemment. Les exigences de pureté dans les applications visées par la présente invention nécessitent donc une élimination maximale de ces impuretés, c'est pourquoi, un filtre 14 peut être placé à l'extrémité du conduit 12. Ledit filtre 14 est par exemple du type séparateur à effet centrifuge, séparateur inertiel et par sédimentation, séparateur électrique, électrofiltre, filtre à manches, séparateurs humide, laveur. La position du filtre peut être en aval ou en amont d'un moyen de compression 16 (par exemple un compresseur) en fonction des caractéristiques dudit moyen de compression 16. En effet dans le cas ou la force de succion du compresseur est suffisante, le filtre peut être placé en amont, avec cependant un risque de dépression en aval des filtres. Si la force de succion du compresseur est insuffisante, les filtres doivent être placés en aval du compresseur.

Le mélange ainsi filtré circule dans un conduit 15 vers un moyen de compression 16. En sortie de ce moyen de compression 16, la pression du mélange comportant au moins du silane, de l'hydrogène et de l'azote est comprise entre 2 bars et 35 bars, de préférence comprise entre 8 bars et 10 bars. La pression préférée est celle qui permet d'aboutir au meilleur compromis entre la taille des équipements de l'appareil (C) selon l'invention et le coût de l'énergie permettant d'élever la pression de travail. Ladite taille des équipements est réduite lorsque la pression est élevée, mais le coût de l'énergie à dépenser pour aboutir à une pression élevé est à prendre en considération. 1 bar = 10⁵ Pa.

Selon une variante de l'invention, une capacité tampon 18 peut-être installée afin de lisser les variations de flux du mélange circulant dans la canalisation 17 en aval dudit moyen de compression 16. La taille et la manière de connecter cette capacité 16 à la canalisation 17 dépendent des flux utilisés et du mode de fonctionnement désiré.

Selon une variante de l'invention, un ou plusieurs systèmes d'élimination d'impuretés pourra être disposé autour du module de compression. En effet, la localisation exacte permettra d'éliminer une majorité d'une ou de plusieurs impuretés préjudiciables à la suite du procédé.

La présence de fluorés peut engendrer des problèmes par exemple de corrosion ou de tenue mécanique des matériaux présents dans l'appareil selon l'invention. Le coût peut être aussi élevé si la présence de composés fluorés nécessite l'utilisation de matériaux particulièrement adaptés donc chers. Le compresseur 16 est particulièrement visé par ces possibles problèmes. Alors, un système d'élimination 19 sera de préférence placé en amont du système de compression 16.

Bien entendu, en l'absence d'impuretés préjudiciables, aucun système d'élimination nécessaire n'est à ajouter.

Selon une variante de l'invention, un moyen de séparation 19 fonctionnant par exemple sur le principe de l'adsorption (par exemple, PSA, TSA : en anglais, Pressure or Thermal Swing Adsorption) est situé en aval du moyen de compression 16 dans le but est d'adsorber les impuretés telles que par exemple H₂O, O₂ ou des composés fluorés voire chlorés. Dans le conduit 20 en sortie du moyen de séparation 19, circule un mélange azote/silane/hydrogène, la pression étant de quelques bars. Un des objectifs de la présente invention est de recycler des gaz, tels que le silane et l'hydrogène, purs. Par gaz pur on entend des gaz comprenant moins de 100 ppm d'impuretés, par exemple moins de 100 ppm d'azote, voire moins de 1 ppm d'impureté, par exemple moins de 1 ppm d'azote. Ces spécifications dépendent de l'application visée. Or le recyclage à une pression de quelques bars d'un mélange de gaz (silane/hydrogène) comprenant moins de 100 ppm d'azote, de préférence moins de 1 ppm d'azote, issu d'un mélange initial (silane/hydrogène) pouvant contenir jusqu'à 90% d'azote est un problème technique à résoudre par la présente invention. C'est pourquoi, un dispositif de séparation cryogénique 21 est situé en aval dudit conduit 20. Un système cryogénique 21, permet de condenser, voire solidifier, le silane (SiH₄) et assure donc la séparation de SiH₄. En fonction des conditions de séparation (pression et température), la phase de silane condensée peut contenir plus ou moins d'azote et d'autres produits lourds. Une purification supplémentaire du silane (colonne à distiller ou TSA par exemple) peut être envisagée suivant les spécifications demandées. En particulier, l'obtention d'un taux d'azote inférieur à 1 ppm peut être efficacement obtenue à l'aide d'une colonne à distiller 23 qui est alimentée par le mélange condensé dans le séparateur 21 et circulant dans la canalisation 22. Par exemple, la colonne à distiller 23 peut-être configurée pour permettre d'éliminer les impuretés dites légères par la canalisation 25 et les impuretés dites lourdes par la canalisation 26. Le silane ayant la pureté souhaitée est alors récupéré dans la canalisation 24.

Il existe différentes méthodes pour réinjecter le SiH₄ purifié dans le réacteur. Soit de manière directe en renvoyant directement le flux dans le système de distribution de SiH₄, soit en passant par des capacités tampon voire du remplissage de bouteilles. De manière préférée, la solution selon l'invention met en oeuvre des capacités tampon (27) qui permettent d'adapter les flux de sortie de la colonne à la demande en gaz du système de distribution. En particulier, un système mettant en oeuvre deux capacités tampon en parallèle, permet de remplir une capacité pendant que l'autre se vide et d'avoir donc un découplage total entre le flux de sortie de la colonne et le flux demandé par le système de distribution. Le remplissage de ces capacités peut par exemple se faire par cryo-remplissage, mode bien connu dans le domaine des gaz produits par voies cryogéniques.

Selon une variante de l'invention, le silane ainsi recyclé et purifié est réinjecté dans la canalisation 4 via la canalisation 28.

Le mélange N₂/H₂ ressortant à quelques bars, de l'étape de séparation effectuée par le système 21, à travers un conduit 29 peut ensuite être séparé à l'aide d'une membrane 30 pour permettre le recyclage de l'hydrogène H₂ si nécessaire. En effet, la distillation du mélange hydrogène/azote n'est pas très aisée du fait des très faibles températures nécessaires. L'obtention d'hydrogène pur avec moins de 100 ppm d'azote, voire moins de 1 ppm d'azote, est classiquement obtenue en utilisant des systèmes basés sur l'adsorption (PSA, adsorption cryogénique ...). Cependant, pour être pleinement opérationnels, ces types d'équipements nécessitent un flux d'entrée ayant des taux d'azote limités (inférieur à environ 20% pour un PSA ou inférieur à 5000 ppm pour un système de cryo-adsorption). L'utilisation d'une membrane permet, à moindre cout, d'appauvrir le mélange en azote de manière à le faire correspondre aux spécifications d'un éventuel système de purification se trouvant en aval. L'azote issu de la séparation avec l'hydrogène pur est de préférence évacué du système (C) au moyen par exemple, d'un évent 31. Une partie de l'azote issu de cette séparation peut également être employé par recyclage pour alimenter la pompe 8, au moyen d'un conduit de recyclage 32. La réutilisation de l'azote n'est probablement financièrement pas pertinente du fait du faible coût de l'azote. On préférera donc mettre l'azote à l'évent 31 plutôt que de le recycler vers la pompe à vide 8 de la chambre de réaction 7.

A la sortie de la membrane 30 par laquelle circule l'hydrogène purifié, l'hydrogène sortant de la membrane peut être utilisé pour la régénération du système de séparation 19 via une canalisation non représentée sur la figure 1 ou alors être aussi réinjecté (recyclé) dans la chambre de réaction 7 via une conduite 33 après avoir subit une purification supplémentaire si nécessaire. Cette purification supplémentaire peut se faire, par exemple par PSA ou par cryoadsoprtion en fonction des spécifications de pureté requises. Selon une variante de l'invention, l'hydrogène circulant dans la canalisation 33 est compressé à l'aide d'un moyen de compression 34 puis acheminé vers le système de purification 36 via la canalisation 35. Le fait de compresser le gaz permet d'optimiser la purification. Par exemple, en cas d'utilisation d'un PSA, la pression de fonctionnement est de l'ordre de 25 bars. L'hydrogène ainsi recyclé et purifié peut être, par exemple réinjecté dans la canalisation 5 à l'aide de la canalisation 37. Selon une variante de l'invention, une ou plusieurs capacités 38 peuvent être utilisées afin de stocker l'hydrogène et de découpler ainsi le flux d'hydrogène recyclé du flux demandé par l'application. Selon une autre variante de l'invention, l'hydrogène recyclé peut être réinjecté dans la capacité servant de source d'hydrogène 2.

Selon une variante de l'invention, la composition des flux de gaz recyclés peut être contrôlée par un système adéquat (FTIR, catharomètre ...) connecté soit sur les canalisations 28 et/ou 37, soit sur les capacités 27 et/ou 38. Les différentes grandeurs mesurées peuvent ainsi être renvoyées à un système de supervision qui peut agir sur les débits des gaz frais injectés afin de contrôler le procédé. Une autre méthode de contrôle de la qualité des gaz recyclés consiste à effectuer un prélèvement des dits gaz sur les lignes 28 et/ou 37 ou dans les capacités 27 et/ou 38, puis de réaliser une analyse ex-situ des ces prélèvements.

Selon un mode de l'invention, l'appareil mettant en oeuvre le procédé objet de la présente invention comporte des réservoirs ou chambres de mélanges (non représentés sur la figure 1). Ces chambres sont destinées à mélanger les gaz recyclés avec des gaz purs issus par exemple des sources 1 et 2. Ces types de mélanges permettent, par exemple, d'amortir les fluctuations de qualité de la composition des gaz recyclés à mélanger avant d'être réinjectés dans la chambre de réaction 7.

Afin que le mélange silane/hydrogène soit injecté dans la chambre de réaction 7 dans les mêmes proportions que le mélange silane/hydrogène circulant dans les conduits 4 et 5 contenant les gaz issus des sources 1 et 2, le rapport silane sur hydrogène en concentrations est contrôlé avant injection dans la chambre de réaction 7.

Selon une variante, le système de séparation cryogénique 21 comprend des échangeurs permettant de réduire la température du mélange. Ces échangeurs sont conçus et dimensionnés afin d'optimiser le bilan énergétique. Le principe repose sur la liquéfaction du silane. Pour ce faire, la température du gaz contenant le silane à liquéfier est conduite à une température inférieure à la température de liquéfaction (température de bulle) du silane en utilisant des échangeurs refroidis en mettant en oeuvre de l'azote par exemple. En effet, il permet facilement de moduler cette température. D'autres sources froides sont utilisables. Ensuite, lorsque le silane se trouve en majorité sous forme liquide, il est nécessaire de séparer les gouttes du gaz résiduaire. On utilise alors un pot de séparation, éventuellement muni d'un ou de plusieurs systèmes de récupération des gouttes afin de récupérer un maximum de gouttes. Une partie de l'azote contenu dans le gaz se liquéfie et/ou se solubilise dans le silane liquide. Or, il est nécessaire de recycler un silane produit de haute pureté, il est donc préférable de purifier ce mélange azote/silane (principalement). De préférence une colonne de distillation dont l'une des sorties sera constituée de silane de haute pureté sera utilisée.

De tels systèmes de séparation cryogénique permettent de mettre en oeuvre le procédé selon l'invention de manière continue.

## Revendications

1. Procédé de recyclage de silane comprenant les étapes successives suivantes :
a) Injection d'un mélange silane pur/hydrogène pur (SiH₄/H₂) dans une chambre de réaction (7) pour fabriquer des couches minces contenant du silicium ;
b) Extraction du mélange : excès de silane non utilisé à l'étape a) / hydrogène (SiH₄/H₂), au moyen d'une pompe (8) mettant en oeuvre un gaz d'alimentation ;
c) Refoulement de ladite pompe (8) à une pression proche de la pression atmosphérique, d'un mélange comprenant au moins du silane (SiH₄), de l'hydrogène (H₂) et une quantité non nulle dudit gaz d'alimentation ;
d) Séparation du silane (SiH₄) du mélange hydrogène/gaz d'alimentation issus du mélange issu de l'étape c), ledit silane obtenu comprenant moins de 100 ppm de gaz d'alimentation, de préférence moins de 10 ppm de gaz d'alimentation, de préférence moins de 1 ppm de gaz d'alimentation ;
**caractérisé en ce qu'**au moins 50%, de préférence 70%, et de préférence encore 80% du silane (SiH₄) issu de l'étape b) est réutilisé après l'étape d) pour une nouvelle étape a).

2. Procédé de recyclage de silane et d'hydrogène mettant en oeuvre le procédé tel que défini à la revendication 1, comprenant en outre une étape de:
e) Purification de l'hydrogène (H₂) issus de l'étape d) telle que le taux de gaz d'alimentation dans l'hydrogène n'est pas supérieur à 100 ppm, de préférence pas supérieur à 10 ppm et de préférence encore pas supérieur à 1 ppm ;
**caractérisé en ce qu'**au moins 50% de l'hydrogène (H₂) et de préférence au moins 85% de l'hydrogène issu de l'étape b) est réutilisé après l'étape e) pour une nouvelle étape a).

3. Procédé selon l'une des revendications 1 ou 2, **caractérisé en ce que** ledit gaz d'alimentation de la pompe (8) est l'azote (N₂).

4. Procédé selon la revendication 3, **caractérisé en ce que** le mélange issu de l'étape c) comprend de 30% à 90% d'azote (N₂), de préférence de 60% à 80% d'azote.

5. Procédé selon l'une quelconque des revendications 1 à 4, comprenant en outre une étape de compression entre les étapes c) et d), au cours de laquelle la pression en sortie de pompe (8), proche de la pression atmosphérique, est augmentée à une pression comprise entre 2 bars et 35 bars, de préférence entre 5 bars et 15 bars et de préférence encore entre 8 bars et 10 bars.

6. Procédé selon l'une quelconque des revendications 1 à 5, **caractérisé en ce que** l'étape d) est effectuée par séparation et/ou distillation cryogénique.

7. Procédé selon l'une quelconque des revendications 1 à 6, **caractérisé en ce que** la fabrication des couches minces dans la chambre de réaction (7) est faite sous vide.

8. Procédé selon l'une quelconque des revendications 1 à 7, **caractérisé en ce que** le rapport : concentration de silane (SiH₄) sur concentration d'hydrogène (H₂) est contrôlé et ajusté si nécessaire avant réinjection, pour une nouvelle étape a), du mélange silane/hydrogène (SiH₄/H₂) comprenant au moins du silane (SiH₄) recyclé selon ledit procédé.

## Patentansprüche

1. Verfahren zum Recycling von Silan, umfassend die folgenden aufeinander folgenden Schritte:
a) Injizieren eines Gemischs aus reinem Silan/reinem Wasserstoff (SiH₄/H₂) in eine Reaktionskammer (7) zur Herstellung von Silicium enthaltenden Dünnschichten;
b) Extrahieren des Gemischs: in Schritt a) nicht verwendeter Silanüberschuss/Wasserstoff (SiH₄/ H₂) mithilfe einer Pumpe (8), wobei ein Einspeisegas eingesetzt wird;
c) Zuführen eines Gemischs, umfassend mindestens Silan (SiH₄), Wasserstoff (H₂) und einer Menge, die nicht null ist, des Einspeisegases durch die Pumpe (8) mit einem Druck nahe dem Atmosphärendruck;
d) Trennen des Silans (SiH₄) von dem Wasserstoff/Einspeisegas-Gemisch, das aus Schritt c) stammt, wobei das erhaltene Silan weniger als 100 ppm Einspeisegas, bevorzugt weniger als 10 ppm Einspeisegas, bevorzugt weniger als 1 ppm Einspeisegas umfasst;
**dadurch gekennzeichnet, dass** mindestens 50 %, bevorzugt 70 % und noch stärker bevorzugt 80 % Silan (SiH₄), das aus Schritt b) stammt, nach Schritt d) für einen neuen Schritt a) wiederverwendet wird.

2. Verfahren zum Recyceln von Silan und Wasserstoff, bei dem das Verfahren nach Anspruch 1 eingesetzt wird, das ferner einen Schritt umfasst zum:
e) Reinigen des Wasserstoffs (H₂), der aus Schritt d) stammt, so dass der Anteil an Einspeisegas in dem Wasserstoff nicht mehr als 100 ppm, bevorzugt nicht mehr als 10 ppm und noch stärker bevorzugt nicht mehr als 1 ppm beträgt;
**dadurch gekennzeichnet, dass** mindestens 50 % des Wasserstoffs (H₂) und bevorzugt mindestens 85 % des Wasserstoffs, der aus Schritt b) stammt, nach Schritt e) für einen neuen Schritt a) wiederverwendet wird.

3. Verfahren nach einem der Ansprüche 1 oder 2, **dadurch gekennzeichnet, dass** das Einspeisegas der Pumpe (8) Stickstoff (N₂) ist.

4. Verfahren nach Anspruch 3, **dadurch gekennzeichnet, dass** das Gemisch, das aus Schritt c) stammt, 30 % bis 90 % Stickstoff (N₂), bevorzugt 60 % bis 80 % Stickstoff umfasst.

5. Verfahren nach einem der Ansprüche 1 bis 4, ferner umfassend zwischen den Schritten c) und d) einen Schritt zur Kompression, in dessen Verlauf der Druck am Ausgang der Pumpe (8), nahe am Atmosphärendruck, auf einen Druck im Bereich zwischen 2 Bar und 35 Bar, bevorzugt zwischen 5 Bar und 15 Bars und noch stärker bevorzugt zwischen 8 Bar und 10 Bar erhöht wird.

6. Verfahren nach einem der Ansprüche 1 bis 5, **dadurch gekennzeichnet, dass** Schritt d) durch Trennung und/oder Tieftemperaturdestillation durchgeführt wird.

7. Verfahren nach einem der Ansprüche 1 bis 6, **dadurch gekennzeichnet, dass** die Herstellung der Dünnschichten in der Reaktionskammer (7) unter Vakuum erfolgt.

8. Verfahren nach einem der Ansprüche 1 bis 7, **dadurch gekennzeichnet, dass** das Verhältnis: Silankonzentration (SiH₄) zu Wasserstoffkonzentration (H₂) für einen neuen Schritt a), falls erforderlich, vor der Reinjektion kontrolliert und eingestellt wird, wobei das Silan/Wasserstoff-Gemisch (SiH₄/ H₂) mindestens gemäß dem Verfahren recyceltes Silan (SiH₄) umfasst.

## Claims

1. Silane recycling method comprising the following successive steps of:
a) injection of a pure silane/pure hydrogen (SiH₄/H₂) mixture into a reaction chamber (7) in order to fabricate thin films containing silicon;
b) extraction of the mixture comprising excess silane unused in step a) and hydrogen (SiH₄/H₂) by means of a pump (8) employing a feed gas;
c) delivery by said pump (8), at a pressure close to atmospheric pressure, of a mixture comprising at least silane (SiH₄), hydrogen (H₂) and a non-zero amount of said feed gas;
d) separation of the silane (SiH₄) from the hydrogen/feed gas mixture resulting from the mixture resulting from step c), said silane obtained comprising less than 100 ppm of feed gas, preferably less than 10 ppm of feed gas, preferably less than 1 ppm of feed gas;
**characterised in that** at least 50 %, preferably 70 %, and more preferably 80 % of the silane (SiH₄) resulting from step b) is reused after step d) for a new step a).

2. Silane and hydrogen recycling method employing the method as defined in claim 1, further comprising a step of:
e) purification of the hydrogen (H₂) resulting from step d) in such a way that the feed gas content in the hydrogen is not greater than 100 ppm, preferably not greater than 10 ppm and more preferably not greater than 1 ppm; **characterised in that** at least 50 % of the hydrogen (H₂) and more preferably at least 85 % of the hydrogen resulting from step b) is reused after step e) for a new step a).

3. Method according to either claim 1 or claim 2, **characterised in that** said feed gas for the pump (8) is nitrogen (N₂).

4. Method according to claim 3, **characterised in that** the mixture resulting from step c) comprises from 30 % to 90 % nitrogen (N₂), preferably from 60 % to 80 % nitrogen.

5. Method according to any of claims 1 to 4, further comprising a compression step between steps c) and d), during which step the delivery pressure of the pump (8), which is close to atmospheric pressure, is increased to a pressure of between 2 bars and 35 bars, preferably between 5 bars and 15 bars and more preferably between 8 bars and 10 bars.

6. Method according to any of claims 1 to 5, **characterised in that** step d) is carried out by cryogenic distillation and/or separation.

7. Method according to any of claims 1 to 6, **characterised in that** the thin-film fabrication in the reaction chamber (7) is carried out in a vacuum.

8. Method according to any of claims 1 to 7, **characterised in that** the ratio of the concentration of silane (SiH₄) to the concentration of hydrogen (H₂) is controlled and adjusted if necessary before reinjection, for a new step a), of the silane/hydrogen mixture (SiH₄/H₂) comprising at least silane (SiH₄) recycled according to said method.
